(19) Europäisches Patentamt
European Patent Office
Office européen des brevets

(11) EP 2 393 025 A1

(12) EUROPEAN PATENT APPLICATION

(43) Date of publication:
07.12.2011 Bulletin 2011/49

(51) Int Cl.:
$G06F\ 17/50$ (2006.01)

(21) Application number: 10165089.3

(22) Date of filing: 07.06.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(71) Applicants:
• IBBT vzw
9050 Ledeberg (BE)
• Universiteit Gent
9000 Gent (BE)

(72) Inventors:
• Peeters, Joris
9000 Gent (BE)
• Bogaert, Ignace
9050 Gentbrugge (BE)
• Cools, Kristof
2330 Merksplas (BE)

(74) Representative: Plas, Axel Ivo Michel et al
IP HILLS NV
Hubert Frère-Orbanlaan 329
9000 Gent (BE)

(54) **A device and method for calculating an interaction integral in a conductive medium**

(57)    The invention concerns a device and method for calculating an interaction integral representing interaction between a first boundary element ($S_i$) and a second boundary element ($S_j$) of an electrically conductive medium with known conductivity. The device and method concentrate processing power in an area dependent on skin depth of the conductive medium and a target tolerance.

Fig. 9

EP 2 393 025 A1

**Description**

**Field of the Invention**

The present invention generally relates to modelling electromagnetic (EM) phenomena in highly conductive media such as copper that is omnipresent in electronic devices. The design and optimization of electronic devices comprising geometrically complex components of various types of materials requires an accurate understanding of the electromagnetic wave phenomena. The invention in particular copes with the scalability problem of calculating interaction integrals containing Green's functions in boundary element based electromagnetic simulations for conductive media.

**Background of the Invention**

Boundary element based electromagnetic simulation tools discretize the surface of objects into a mesh of small elements, e.g. triangles or more generally polygons. The electromagnetic interaction between these elements is expressed through integral equations: the Boundary Integral Equations or BIE. These equations enforce the boundary conditions at the interfaces between materials. The solution of the integral equations can then be used to calculate the electromagnetic fields at any desired point in the object.

The Method of Moments or MoM is one of the most powerful boundary element based methods for resolving electromagnetic simulations in piecewise homogeneous media. In the Method of Moments, electric and magnetic current densities are expanded in surface elements. The electromagnetic interaction between the surface elements is expressed through a matrix of interaction integrals, containing the so called Green's functions that represent the interaction between expansion functions for the electric surface current density and magnetic surface current density. For accurate electromagnetic simulations, these interaction integrals have to be determined with high accuracy. Two known techniques to calculate these interaction integrals are named Singularity Extraction or SE and Singularity Cancellation or SC.

The Singularity Extraction or SE technique relies on the existence of an analytic solution to regularise the integrand of the interaction integrals. The remaining, regular part is handled with a numerical quadrature rule.

The Singularity Cancellation or SC technique regularises the integrand of the interaction integrals through a suitable coordinate transformation, e.g. a transformation to polar coordinates.

The known SE and SC techniques assume that the numerator of the Green's functions is a well-behaving function with a fairly small absolute value of the derivative. In highly conductive media, these existing solutions however cannot determine the interaction integrals in a scalable and accurate way. For such highly conductive media like the widespread copper, the Green's function has a strongly pulsed behaviour that is extremely localized near the origin. Indeed, for highly conductive media, the Green's function can be demonstrated to become both highly oscillatory and exponentially damped. As a result thereof, the known SE and SC techniques that neglect this oscillatory and exponentially damped behaviour lead to erroneous or inaccurate EM simulations inevitably requiring additional cycles in the design, prototyping and development processes of devices that contain such highly conductive materials. Accurate calculation of the interaction integrals with the known SE or SC technique requires augmenting the quadrature points substantially as a result of which the computation time and processing requirements increase excessively. This is the so called scalability problem of resolving the Green's functions in highly conductive media.

In the article "Evaluation of Green's Function Integrals in Conducting Media", published in IEEE Transactions on Antennas and Propagation, Vol. 52, No. 12, Dec. 2004, the authors Swagato Chakraborty and Vikram Jandhyala present a method for accurately computing interaction integrals in conducting media. The method is based on a two-region formulation being a homogeneous lossless background medium and a conductor, and utilizes dedicated potential integrals. Although this article recognizes the problem of evaluating interaction integrals in highly conductive media, the method presented by Chakraborty and Jandhyala does not lead to a scalable solution, i.e. a solution whose calculation time is independent of the conductivity of the medium.

US Patent 6,051,027 entitled "Efficient Three Dimensional Extraction" mentions the excessive computation time and memory usage of finite element schemes used in electromagnetic simulation tools for ICs and PCBs. These finite element schemes discretize the entire 3 dimensional volume yielding a large number of points. US 6,051,027 proposes to reduce the computation time and memory requirements by decoupling the far field computation from the near field computation when calculating layered Green's functions. Whereas the far field effect is extracted from a compressed, pre-filled database, the near field effect is real-time calculated using a prioritization mechanism dependent on the amplitude of the source and distance between regions of interest.

The solution proposed in US 6,051,027 is applicable to finite element based methods, more particularly to such methods wherein layered Green's functions are calculated. These layered Green's functions contain a far field portion that can be pre-calculated and stored in a lookup database. The method however does not lead to a scalable approach for conductive media, since it is only the calculation of the Green's function that is accelerated, not the computation of the interaction integrals. Hence, the method takes no benefit of knowledge of the Green's functions' behaviour for conductive media.

US Patent Application 2009/0228847 entitled "High-Frequency VLSI Interconnect and Intentional Inductor Impedance Extraction in the Presence of a Multi-Layer Conductive Substrate" also mentions the scalability problem of conventional methods for extraction of electromagnetic properties in the presence of conductive substrates. These conventional methods are too expensive in terms of computation time and/or memory. The solution proposed in US 2009/0228847 consists in approximating the conductive substrate's contribution to the Green's function at one or more frequencies of interest from design information that comprises profile information for the substrate. In other words, geometrical information on the circuit's design is used to pre-calculate certain contributions to the Green's function.

The solution proposed in US 2009/0228847 requires that geometrical information is available in a certain format. Furthermore, the method is only applicable in the presence of a multi-layer conductive substrate over or under which an electrical circuit design is implemented.

US Patent 6,353,801 entitled "Multi-Resolution Adaptive Solution Refinement Technique for a Method of Moments-Based Electromagnetic Simulator" describes a multi-resolution based refinement for boundary element calculations. More particularly, US 6,353,801 proposes to refine the mesh size iteratively and to eliminate capacitive/inductive base functions whose contributions to the surface current stay below a certain capacitive or inductive threshold value. This way, US 6,353,801 deals with the problem of EM simulators that are very computer resource intensive in finding a better trade-off between simulation accuracy and simulation speed.

Although the multi-resolution aspect of the technique proposed in US 6,353,801 reduces the calculations, the solution relies on an iterative approach where the interaction matrix of a previous iteration can be used in the next iteration. The method is not specific for conductive media and takes no benefit of knowledge of the Green's functions' behaviour for such conductive media. For conductive media, the approach would not be scalable.

It is an objective of the current invention to disclose a device and method for calculating interaction integrals in boundary element based electromagnetic simulations for highly conductive media which overcome the above identified shortcomings of existing solutions. In particular, it is an objective to disclose such device and method that is scalable, i.e. with a calculation time that is independent of the conductivity. It is a further objective to provide a device and method for calculating the interaction integrals accurately in conductive media, thereby avoiding extra cycles in the design and development process of devices as a result of erroneous or inaccurate electromagnetic simulations.

## Summary of the Invention

According to the current invention, the above cited shortcomings of existing solutions are overcome and the above mentioned objectives are realized by a device for calculating an interaction integral representing interaction between a first boundary element and a second boundary element of an electrically conductive medium with known conductivity, as defined by claim 1, the device being adapted to concentrate processing power in an area dependent on skin depth of the conductive medium and a target tolerance.

Thus, the invention consists in a tool for accurately determining the interaction integral containing the Green's function by concentrating the processing power into an area where the interaction is relevant. The key to accurately integrate the strongly pulsed and rapidly declining Green's function for highly conductive media lies in focusing the numerical quadrature points in those regions where the Green's function has a non-negligible value. The invention is based on the insight that the more distant the interaction is, the less accurate its evaluation needs to be. The invention further relies on the property that the Green's function is extremely localized around the origin for conductive media and shows a rapid decay away from the origin. By concentrating the quadrature points and processing power in an area that is dependent on the skin depth, i.e. dependent on the material's conductivity and the frequency, it can be assured that the calculation effort is optimally exploited to quantify non-negligible contributions, and no processing time and resources are wasted to determine negligible contributions to the Green's function, which would be the case if traditional techniques would be applied with an increased amount of quadrature points. The target tolerance further enables to control the desired accurateness. It essentially imposes a maximum absolute error on the integral by determining for instance the distance beyond which the Green's function shall be neglected.

Optionally, as defined by claim 2, the device for calculating an interaction integral according to the current invention comprises:

- means for calculating an inner integral, adapted to focus quadrature points for calculation of the inner integral in a second area of the second boundary element, the second area being determined by a cut-off distance depending on the skin depth.

Indeed, in a preferred embodiment of the invention, the area wherein the quadrature points are concentrated is determined by a certain cut-off value or cut-off distance. The cut-off distance can be chosen to depend on the skin depth of the material, i.e. depend on the conductivity of the material and the frequency, in such a manner that the numerator of the Green's function beyond this cut-off distance drops below a fraction ε of its value in the origin:

$$r_{cut} = -\frac{\sqrt{2}.\ln\varepsilon}{|k|} = -\delta.\ln\varepsilon \qquad (1)$$

Herein,

$r_{cut}$ represents the cut-off distance;

ε represents a fraction of the Green's function's numerator value in the origin below which the contribution will be neglected;

k represents the wave number which can be approximated as follows for conductive materials:

$$k \approx \frac{1-j}{\delta} \qquad (2)$$

δ represents the material's skin depth and is given by:

$$\delta = \sqrt{\frac{2}{\omega\mu\sigma}} \qquad (3)$$

Herein, ω represents the angular frequency or 2πf, f representing the frequency, μ represents the absolute magnetic permeability of the material, and σ represents the material's conductivity.

Beyond the cut-off distance $r_{cut}$ the contribution will be neglected. With this knowledge, the inner integral can be evaluated to any desired tolerance independent of the material's conductivity.

Further optionally, as defined by claim 3, the radial component of the inner integral is determined through a Double Exponential or DE transform.

Indeed, while the polar coordinate transform would be able to cancel a 1/R singularity of the integrand, an $1/R^2$ singularity has to be tackled. In addition, due to the conductive property, the Green's function will in any case have its least smooth behavior around p=0. An interesting approach to tackle such integrands with possible endpoint singularities is the Double Exponential or DE transform, essentially mapping a [-1, 1] region onto a [-∞, +∞] region that can be handled with a trapezoidal rule to exponential accuracy.

Also optionally, as defined by claim 4, the device for calculating an interaction integral according to the current invention may comprise:

- means for calculating an outer integral over a first area of the first boundary element, the first area being determined by the intersection of the first boundary element with a volume obtained by projecting the second boundary element over a predefined cut-off distance depending on the skin depth.

Thus, in a preferred embodiment of the invention, also the integration domain of the outer integral is reduced by focusing the quadrature points in those regions where the integrand changes rapidly. The reduced domain preferably is determined as the intersection between the first boundary element Si, and the projection of the second boundary element Sj over a certain distance. This distance is preferably dependent on the material's skin depth, i.e. the conductance and the frequency, and determined in such a manner that contributions to the outer integral resulting from interaction between the first boundary element and projections of the second boundary element beyond the cut-off distance, are negligibly small and fall within the acceptable target tolerance.

Further optionally, as defined by claim 5, the cut-off distance is directly proportional to said skin depth.

Indeed, as already demonstrated here above, the cut-off distance may for instance be determined by:

$$r_{cut} = -\frac{\sqrt{2}.\ln\varepsilon}{|k|} = -\delta.\ln\varepsilon \qquad (1)$$

with δ representing the material's skin depth, given by:

$$\delta = \sqrt{\frac{2}{\omega\mu\sigma}} \qquad\qquad (3)$$

As is indicated by claim 6, the cut-off distance in a preferred embodiment of the device for calculating an interaction integral according to the invention is determined through the target tolerance.

Thus, in a preferred embodiment, the cut-off distance that is used to control the area wherein the quadrature points for the inner and outer integrals are concentrated, on the one hand takes into account the conductivity of the material, and on the other hand is determined by the target tolerance ε. This is for instance the case when formula (1) is used. The cut-off distance in other words essentially imposes a maximum absolute error on the integral.

Optionally, as defined by claim 7, the skin depth is smaller than the typical mesh size $d_m$ for the first boundary element and the second boundary element.

Indeed, calculation of the interaction integrals according to the present invention is advantageous when the skin depth is below a certain limit. This limit depends on the typical size $d_m$ of the mesh elements in the Boundary Elements method. In the case of high frequencies, $d_m$ will be of the order of $\frac{\lambda}{10}$ with λ representing the wavelength in the background medium, while in the low frequency regime, $d_m$ will be determined by the geometry and can be considered independent of the frequency. Higher values of the skin depth may lead to situations where the approach according to the current invention is no longer required since the dimensions of the boundary elements become even smaller than the skin depth δ.

In addition to a device for calculating an interaction integral as defined by claim 1, the present invention also relates to a corresponding method for calculating an interaction integral representing interaction between a first boundary element and a second boundary element of an electrically conductive medium with known conductivity, the method concentrating processing power of a processing device in an area dependent on skin depth of the medium and a target tolerance. This method is defined by claim 8.

Furthermore, the present invention also relates to a corresponding software program containing instructions to perform the method of claim 8. This software program is defined by claim 9.

**Brief Description of the Drawings**

Fig. 1 illustrates the absolute value of the Green's function g(r) for different values of the material's conductivity;

Fig. 2 illustrates the pulsed behaviour of the Green's function's numerator for conductive media;

Fig. 3 illustrates the finding of a reference point $r_0$ for a coordinate transformation used when calculating the inner integral in an embodiment of the method according to the invention;

Fig. 4 illustrates the division of the second boundary element in sub-triangles when calculating the inner integral in an embodiment of the method according to the invention;

Fig. 5 illustrates truncating the integration domain when calculating the inner integral in an embodiment of the method according to the invention;

Fig. 6 illustrates truncating the radial integration domain when calculating the inner integral in an embodiment of the method according to the invention;

Fig. 7 illustrates the integration domain when calculating the inner integral in an embodiment of the method according to the invention;

Fig. 8 illustrates a first step in reducing the integration domain when calculating the outer integral in an embodiment of the method according to the invention;

Fig. 9 illustrates a second step in reducing the integration domain when calculating the outer integral in an embodiment of the method according to the invention; and

Fig. 10A, Fig. 10B and Fig. 10C illustrate the process of reducing the integration domain when calculating the outer integral in an embodiment of the method according to the invention.

**Detailed Description of Embodiment(s)**

As explained here above, discretising the Boundary Integral Equations or BIE in the Method of Moments leads to a dense linear system, the matrix elements of which describe the interaction, through the Green's function, between expansion functions of electric and magnetic surface current densities. Scattering at objects with a permittivity $\varepsilon$ and permeability $\mu$, but neither infinitely lossy, requires the introduction of two equivalent surface current densities, electric and magnetic, which can be solved for as the solution of the Poggio-Miller-Chang-Harrington-Wu-Tsai (PMCHWT) BIE. In this patent application, it will be assumed that the surface current densities are expanded into Rao- Wilton-Glisson (RWG) functions, which will be denoted as b(r), although the invention technique has a broader field of application. The resulting matrix elements require the calculation of the following integrals over the first boundary element $S_i$ of the test functions $b_i$ and the second boundary element $S_j$ of the basis functions $b_j$:

$$I_T = \int_{S_i} b_i(r) . \int_{S_j} \overline{G}_{ee}(r\text{-}r') . b_j(r') \, dS'dS \tag{4}$$

$$I_K = \int_{S_i} b_i(r) . \int_{S_j} \overline{G}_{me}(r\text{-}r') . b_j(r') \, dS'dS \tag{5}$$

Herein, $\overline{G}_{ee}(r\text{-}r')$ represents the electric-electric Green's dyadic and $\overline{G}_{me}(r\text{-}r')$ represents the magnetic-electric Green's dyadic, given by:

$$\overline{G}_{ee}(r) = -j\omega\mu \left( \overline{I} + \frac{\nabla\nabla}{k^2} \right) g(|r|) \tag{6}$$

$$\overline{G}_{me}(r) = (\nabla \times \overline{I}) g(|r|) \tag{7}$$

Using the fact that the RWG functions are divergence conforming, $I_T$ can be written in mixed potential form, reducing the $1/R^3$ hyper-singularity to an integrable $1/R$ singularity, with $R = |r - r'|$. After these operations, three different integrals can be identified:

$$I_1 = \int_{S_i} b_i(r) . \int_{S_j} g(R) b_j(r') \, dS'dS \tag{8}$$

$$I_2 = \int_{S_i} [\nabla . b_i(r)] . \int_{S_j} g(R) \left[ \nabla' . b_j(r') \right] dS'dS \tag{9}$$

$$I_3 = PV \int_{S_i} b_i(r) . \int_{S_j} \nabla g(R) \times b_j(r') \, dS'dS \tag{10}$$

Herein, PV indicates the Principal Value of the integral. When the boundary elements of $b_i$ and $b_j$ overlap in at least a point, the above integrals have a non-continuous integrand, although they are integrable. For $S_i = S_j$, i.e. the self patch case, $I_3$ becomes zero. In order to determine these integrals over a triangle, for each possible b, it suffices to calculate the following integrals:

$$I_{t1} = \int_{S_i} r . \int_{S_j} g(R) r' \, dS'dS \tag{11}$$

$$I_{t2} = \int_{S_i} \int_{S_j} g(R) \, dS'dS \tag{12}$$

$$I_{t3}=PV \int_{S_i} \int_{S_j} \nabla g(R) \times r' \, dS' dS \tag{13}$$

To obtain the integrals $I_1$, $I_2$ and $I_3$, these integrals $I_{t1}$, $I_{t2}$ and $I_{t3}$ are required, in addition to some others that are merely variations in terms of the presence or absence of r or r'. The reason both $I_{t1}$ and $I_{t2}$ are included here, instead of just one of them, is to demonstrate that the presence of r has no mentionable influence on the achievable accuracy. In summary, if the three integrals above can be evaluated efficiently and accurately, this also guarantees accurate evaluation of all integrals that are required in the impedance matrix.

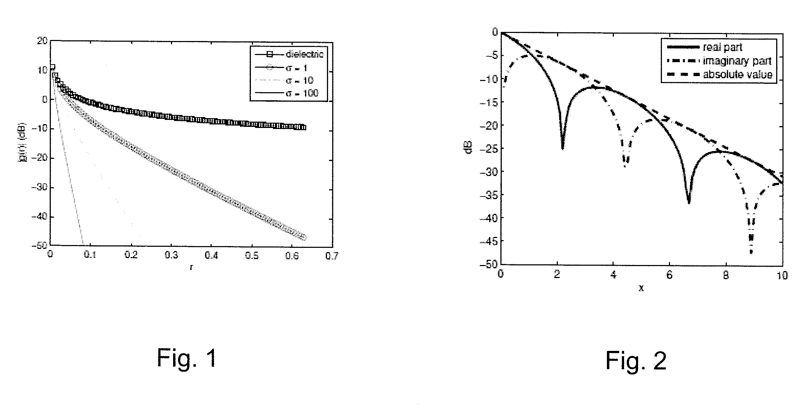

In order to explain the difficulties that occur when calculating the above interaction integrals for conductive media, it is necessary to look at the behavior of the Green's function for various values of the conductivity σ. Fig. 1 shows the absolute value of the Green's function g(r) for materials with respective conductivity values σ=1, σ=10 and σ=100. The pulsation or rotational frequency ω is chosen equal to 300 MHz. The distance r is varied from 0 to λ/10, with λ representing the free space wavelength (with $\varepsilon_r = \mu_r = 1$). From Fig. 1, it can be seen for instance that even a relatively poor conductor with conductivity σ = 100 dampens the Green's function by more than five orders of magnitude over a distance of about λ/60. Copper, one of the most widespread conductors in industry, has a conductivity $\sigma \approx 59{,}6.10^6$ Sm$^{-1}$, leading to a Green's function that is extremely localized around the origin. This rapid declining behavior of the Green's function for highly conductive media explains why straightforward application of existing techniques such as Singularity Extraction (SE) or Singularity Cancellation (SC) fail, because they neglect the highly oscillatory but at the same time exponentially damped character of $e^{-jkr}$.

In order to illustrate an embodiment of the invented approach for calculating these integrals in conductive media in a scalable and accurate manner, the explanation will be based on $I_{t2}$. Further, it will also be shown how both $I_{t1}$ and $I_{t3}$ can be treated similarly. Thus, in the following paragraphs, an embodiment of the invented method will be described for efficiently evaluating the following integral for arbitrary values of the conductivity σ:

$$I_{ij,2}=\int_{S_i} I_j(r,r') dS \tag{14}$$

In order to achieve this goal, a dedicated approach for calculating both the inner and outer integrals will be described.

The inner integral is expressed as follows:

$$I_j(r)=\int_{S_j} g\big(|r-r'|\big) dS' \tag{15}$$

Although coordinate r can refer to anywhere in space, the most challenging and practically interesting cases are when r is very close to the second boundary element $S_j$ or even in it. The key to accurately integrate the strongly pulsed behavior of the Green's function g(r) lies in focusing the numerical quadrature points only in those regions where the Green's function has a non-negligible value, based on a certain tolerance ε.

The wave number in a good conductor approximately satisfies:

$$k \approx \frac{|k|}{\sqrt{2}}\left(1\text{-}j\right) \tag{16}$$

with $k \approx \sqrt{\omega\mu\sigma}$. This approximation valid for conductive materials allows to approximately express the numerator of the Green's function in terms of |kr| only:

$$e^{-jkr} \approx \left[\cos\frac{|kr|}{\sqrt{2}} - j.\sin\frac{|kr|}{\sqrt{2}}\right] e^{-\frac{|kr|}{\sqrt{2}}} \tag{17}$$

Fig. 2 illustrates the behavior of this function with x = |kr|. Fig. 2 illustrates that beyond a certain electrical length, the numerator of the Green's function drops below a fraction ε compared to its value in the origin. As such a certain cut-off value of r can be determined, beyond which the remainder can be neglected, more precisely:

$$r_{cut} = -\frac{\sqrt{2}.\ln\varepsilon}{|k|} = -\delta.\ln\varepsilon \tag{1}$$

Herein:

$r_{cut}$ represents the cut-off distance;
ε represents a target tolerance value;
k represents the wave number; and
δ represents the material's skin depth and is given by:

$$\delta = \sqrt{\frac{2}{\omega\mu\sigma}} \tag{3}$$

In the latter formula, ω represents the angular frequency or $2\pi f$, f representing the frequency, μ represents the absolute magnetic permeability of the material, and σ represents the material's conductivity.

With the knowledge of equation (1), the inner integral (15) can be evaluated to any desired tolerance ε independent of σ. As a first step, a similar transform as in the Singularity Cancellation method may be employed. Such transform allows for more flexibility in the integrand and will in fact enable to treat the inner integrals of $I_{t1}$, $I_{t2}$ and $I_{t3}$ in an identical manner despite their different kernel. With respect to a carefully selected $r_o$ the integral $I_j(r)$ expressed in (15) is transformed to polar coordinates (ρ, φ):

$$I_j(r) = \int_{\phi_1}^{\phi_2} d\phi \int_{\rho_1(\phi)}^{\rho_2(\phi)} g\left(\left|r-(r_0+\rho u_\rho)\right|\right) \rho d\rho \tag{18}$$

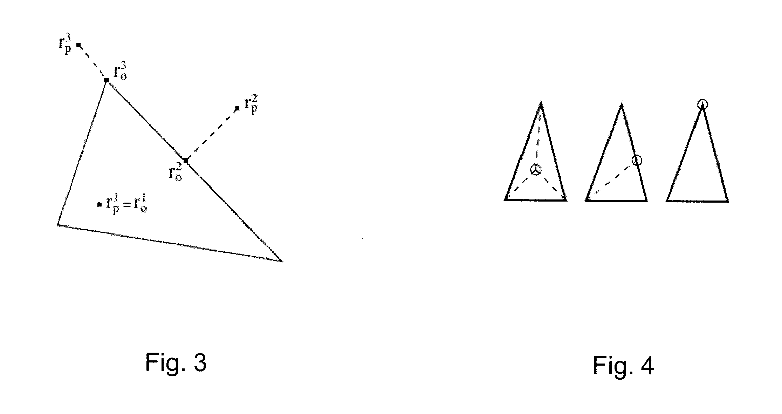

The point $r_o$ is found by first projecting r into the plane of the triangle $S_j$. The projection is referenced by $r_p$ in Fig. 3. If $r_p$ lies within the second boundary element $S_j$, it is equal to $r_o$. If $r_p$ lies outside the triangle $S_j$, $r_o$ is the point on the edge of the triangle $S_j$ that lies closest to $r_p$. The process of finding $r_o$ is illustrated for three different possibilities of rp by Fig. 3.

Once $r_o$ is determined, the second boundary element $S_j$ is divided into one, two or three triangles depending on the location of $r_o$, each having $r_o$ as one of their corners. This is illustrated in Fig. 4 where the location of $r_0$ is indicated by the small circle. Left, $r_0$ lies in the triangle which is subdivided into three parts. In the middle $r_0$ lies on the edge of the triangle which is subdivided into two parts. Right, $r_0$ lies on the corner of the triangle and no subdivision is needed. The integral can be expressed as the sum of the integrals over these sub-triangles.

The integration over one sub-triangle can be rewritten as follows:

$$I_j(r) = \int_0^{\phi_e} d\phi \int_0^{\rho_e(\phi)} g\left(\left|r-(r_0+\rho u_\rho)\right|\right) \rho d\rho \tag{19}$$

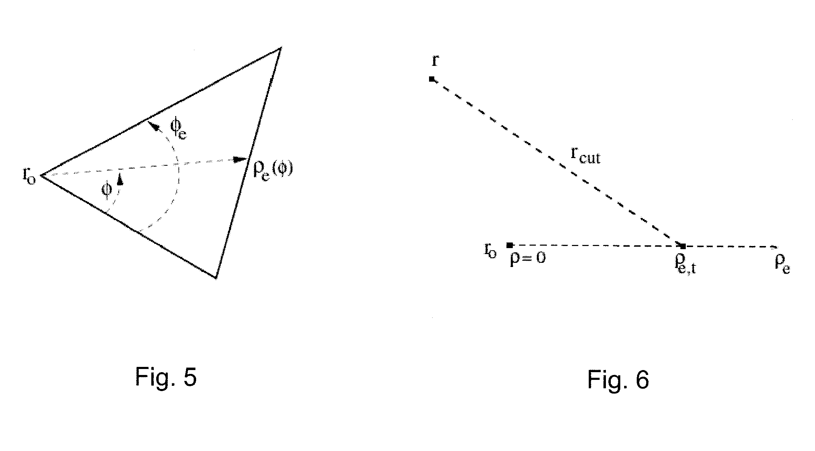

The integration domain for the separate sub-triangles is illustrated by Fig. 5.
The radial integration for a sub-triangle is given by:

$$I_j(r,\phi) = \int_0^{\rho_e(\phi)} g\left(\left|r-(r_0+\rho u_\rho)\right|\right) \rho d\rho \tag{20}$$

The endpoint of the integration $\rho_e(\varphi)$ is dependent on the triangle shape, on the angular coordinate and also on the value of the cut-off distance $r_{cut}$ that may truncate the integration domain. The latter occurs when the endpoint is further away from r than the distance $r_{cut}$. In that case, the integration is carried out from $\rho=0$ to $\rho=\rho_{e,t}$, such that the new endpoint is $r_{cut}$ away from r. This is illustrated by Fig. 6. Clearly, this cut-off does not compromise the accuracy due to the rapid decay of the Green's function.

Regarding the shape of the integrand, it is noted that, while the polar coordinate transform would be able to cancel out a 1/R singularity, $I_{3j}$ leads to a $1/R^2$ singularity. In addition, due to the conductive behavior, the function will in any case have its least smooth behavior around p=0. An interesting approach to tackle such integrands with possible endpoint singularities is the Double Exponential or DE transform, known for instance from the article "Discovery of the Double Exponential Transformation and Its Developments" from the author M. Mori. This DE transform essentially maps a [-1, 1] region onto a [-∞,+∞] region that can be handled with a trapezoidal rule to exponential accuracy. This allows for the desired flexibility in terms of kernel and expansion functions. Suppressing dependencies of $\varphi$ and assuming $\rho_e$ to indicate the integration endpoint, whether or not truncated to $\rho_{e,t}$, the radial integrand now becomes:

$$I_j(r,\phi)=\frac{\rho_e}{2}\int_{-\infty}^{+\infty} g\left(\left|r-\left(r_0+\rho(t)u_{\rho(t)}\right)\right|\right)\rho(t)\psi'(t)dt \qquad (21)$$

Herein:

$$\rho(t) = \frac{\rho_e}{2}\psi(t) + \frac{\rho_e}{2} \qquad (22)$$

and $\Psi(t)$ represents the so called double exponential transform, given by:

$$\psi(t)=\tanh\left(\frac{\pi}{2}\sinh(t)\right) \qquad (23)$$

The use of the truncation distance $r_{cut}$ essentially imposes a maximal absolute error on the integral. If the interaction distance d is well beyond the skin depth $\delta$, this may lead to a large relative error because the value of the integral is very small. However, in the Method of Moments scheme, it is pointless to evaluate these integrals to higher precision because they barely contribute. Essentially, the more distant the interaction, the less accurate its evaluation needs to be. That is exactly what the use of the cut-off distance $r_{cut}$ according to the present invention accomplishes.

Having control over the radial integral, it is now used as the integrand for the angular quadrature:

$$I_j(r)=\int_0^{\phi_e} I_j(r,\phi)d\phi \qquad (24)$$

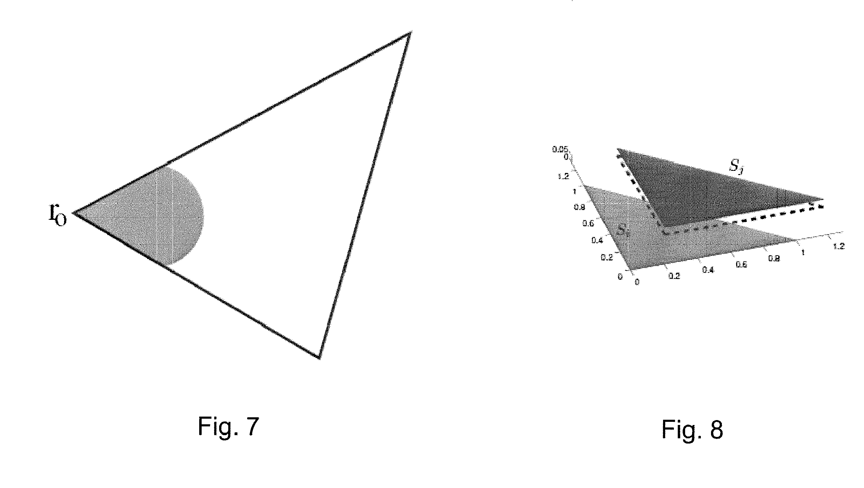

Regarding the choice of quadrature rule and number of sample points needed to evaluate the integral (24), it is worth noticing that when $r_{cut}$ is small compared to the dimensions of the triangle, the integrand is actually not strongly dependent on $\varphi$ because in that case the integral has to be determined only over a limited portion of the triangle. This is illustrated in Fig. 7 where the integration domain is shown when $r_{cut}$ is smaller than the dimensions of the triangle. As such, in those cases, as little as one integration point is usually sufficient. When the conductivity is high, these cases will occur quite often and it is worth detecting them. In contrast, when $r_{cut}$ becomes larger, the integration domain becomes the entire triangle. If the complete triangle plays a role, then a Gaussian quadrature rule is employed. For most practical purposes, 8 sample points in $\varphi$ turn out to be sufficient.

The previously described steps allow for efficient and accurate evaluation of the inner integral as expressed in (18). Application of the DE technique and the introduction of the cut-off distance $r_{cut}$ make the calculation time and accuracy independent of the material's conductivity. In the following paragraphs will be described how the inner integral serves as the integrand of the outer integral, over the first boundary element that is assumed to be a triangle $S_i$.

The outer integral is given by:

$$I_{ij,2} = \int_{S_i} I_j(r,r')dS \qquad\qquad (25)$$

The others have a similar form and can be treated in a completely identical manner as will be described in the following paragraphs. However, for the sake of clarity, the following explanation will be focusing on $I_{ij,2}$.

For the inner integral, the key to efficient evaluation is a concentration of quadrature points in the regions where the integrand is non-negligible through the choice of a cut-off distance $r_{cut}$ dependent on the material's skin depth and the use of the DE transform. A similar objective lies behind the philosophy of the proposed method to evaluate the outer integral expressed in (25).

As an example, and to illustrate the difficulties, Fig. 8 shows two triangles $S_i$ and $S_j$ that, when projected onto each other, overlap only partially. The dashed line in Fig. 8 represents the projection of the top triangle $S_j$ on the plane of the bottom triangle $S_i$. When the conductivity is high, the parts on $S_i$ that are not very close to $S_j$, e.g. the parts that are not within the $r_{cut}$ range as previously determined, will hardly contribute to the outer integral (25). If the two triangles are parallel and above each other, the integrand will in fact hardly change at all. The only regions on $S_i$ where the outer integrand is not smooth are those that are very close to an edge of $S_j$ because there, the inner integrand and hence the result of the inner integration changes rapidly. In order to accurately evaluate the integral, these latter regions will require special care.

The calculation tool and method according to the current invention are designed to determine those parts of $S_j$ that contribute to the outer integral and to focus the quadrature points in those regions where the integrand changes rapidly.

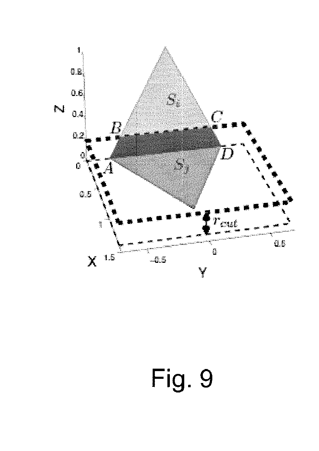

Thereto, in a first step, the integration region on $S_i$ is reduced by eliminating those parts that are too far from the plane of $S_j$ to give any contribution. This is obtained by calculating the intersection, if any, between $S_i$ and the volume between two planes, one at a distance $r_{cut}$ below and parallel to $S_j$ and a similar plane above $S_j$. Depending on the configuration, this intersection represents a single polygon with three, four or five edges. If there is no intersection, $S_i$ is too far away from $S_j$ and the entire interaction integral, in view of the previously chosen target tolerance $\varepsilon$, can be considered zero. This process is illustrated by Fig. 9. Therein, the domain of $S_i$, lying in the YZ-plane, is reduced to the dark shaded area, i.e. the polygon ABCD in Fig. 9, that represents the intersection between $S_i$ and the infinite volume in between the plane of $S_j$, i.e. the dashed thin line in the XY-plane in Fig. 9, and its upward projection over a distance $r_{cut}$, i.e. the dashed bold line in Fig. 9.

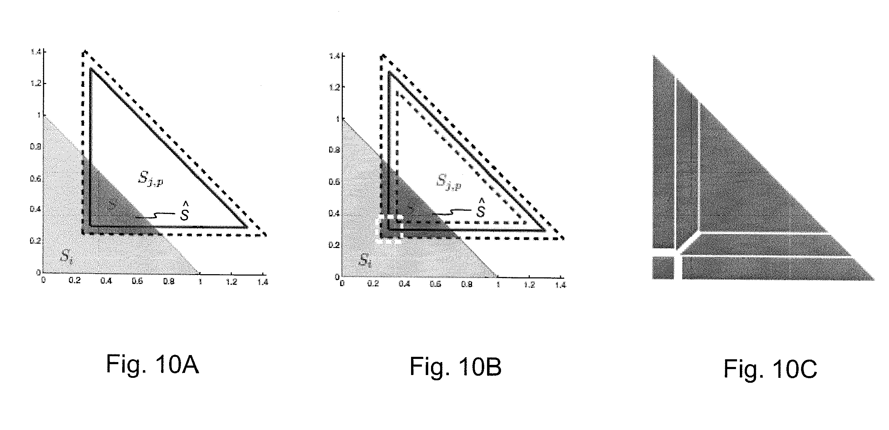

The next step attempts to further reduce the integration domain and also identifies those regions where a rapid change of the integrand can be expected. This in turn leads to a subdivision of the integration domain in judiciously chosen sub-triangles, such that in the end quadrature points are distributed in a manner where the overall integration precision is guaranteed. In order to achieve this, $S_j$ is first projected onto the plane of $S_i$. This projection is subsequently extended in the plane of $S_i$ with polygons, covering a distance of at least $r_{cut}$ from the original projection. The reduced integration domain for the outer integral is then determined as the intersection between $S_i$ and $S_j$'s projection including its extensions. This process is illustrated by Fig. 10A, Fig. 10B and Fig. 10C.

In the particular example illustrated by Fig. 10A, Fig. 10B and Fig. 10C, the plane of triangle $S_j$ is parallel to that of $S_i$, the geometry being shown in Fig. 8. The solid black line in Fig. 10A represents the projection $S_{j,p}$ of $S_j$ in the plane of $S_i$. This projection $S_{j,p}$ is first extended over a distance $r_{cut}$ to the outside. This extension is also shown in Fig. 10A via the dashed lines. The integration over $S_i$ can then be restricted to the darkly shaded area, denoted S in Fig. 10A and Fig. 10B.

Referring to the reasoning put forward here above with respect to the integration over $\varphi$ in expression (24), it is clear that the integrand will not vary uniformly over S. In order to guarantee the overall integration precision, the boundary of the projected triangle $S_{j,p}$ is also extended to the inside as depicted in Fig. 10B, finally leading to the subdivision of S in elementary integration polygons, six in this particular example, as shown in Fig. 10C. The numerical integration over these polygons leads to an overall positioning of the sample points accounting for the exponential variation of the integrand imposed by the Green's functions, as such making sure that the precision obtained for the inner integration does not get compromised when performing the outer integration.

To further illustrate the principles put forward by means of the example of Fig. 10A, Fig. 10B and Fig. 10C, reference is made to the example shown in Fig. 9. In this special case, the projection $S_{j,p}$ of $S_j$ on $S_i$ reduces to the line AD in Fig. 9, as the planes of $S_i$ and $S_j$ are perpendicular. Applying the procedure followed in the example of Fig. 10A, Fig. 10B and Fig. 10C then simply amounts to the reduction of the outer integration domain to the polynomial ABCD in Fig. 9.

The combination of the first and second steps described here above guarantees that the integrand in each polygon is non-negligible and that each possible steep variation is covered by one polygon.

In a final step, the actual integration needs to be carried out over these domains. The easiest approach, which delivers accurate results, is to divide each polygon into triangles and then consider all these triangles separately. Numerical quadrature over a triangle is already present in most implementations, reducing the amount of programming required.

It is noticed that the critical parameter in determining the behavior of the integrand is $\frac{\delta}{d_m}$, with $d_m$ being the typical size of the mesh elements. Taking a closer look at realistic values of $\frac{\delta}{d_m}$, two frequency ranges need to be treated. In the case of high frequencies, $d_m$ will be of the order of $\frac{\lambda}{10}$ with $\lambda$ representing the wavelength in the background medium, while in the low frequency regime, $d_m$ will be determined by the geometry and can be considered independent of the frequency. In the high frequency regime, with $d_m \approx \frac{\lambda}{10}$, the following is valid:

$$\frac{\delta}{d_m} \approx \frac{10}{\pi c} \sqrt{\frac{\omega}{2\mu\varphi}} \qquad (26)$$

When the frequency increases, the skin depth decreases proportional to $\frac{1}{\sqrt{\omega}}$, but the discretisation of the triangles as $\frac{1}{\omega}$, eventually leading to a situation where the proposed approach is no longer required since the dimensions of the triangles become even smaller than $\delta$. However, for copper, $\frac{\delta}{d_m} = 1$ for $\omega = 1{,}4.10^{18}\text{s}^{-1}$ or $f = 2{,}2.10^{5}$ THz, so in practice any high frequency simulation for the microwave and millimeter wave range involving copper or other highly conductive materials requires calculation of the interaction integrals according to the invention as previously described. At low frequencies, the following is valid:

$$\frac{\delta}{d_m} = \frac{1}{d_m} \sqrt{\frac{2}{\omega\mu\varphi}} \qquad (27)$$

and the parameter depends both on the frequency and the geometry.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

**Claims**

1. A device for calculating an interaction integral representing interaction between a first boundary element ($S_i$) and a second boundary element ($S_j$) of an electrically conductive medium with known conductivity, **CHARACTERIZED IN THAT** said device is adapted to concentrate processing power in an area dependent on skin depth of said medium and a target tolerance.

2. A device for calculating an interaction integral according to claim 1, said device comprising:

   - means for calculating an inner integral, adapted to focus quadrature points for calculation of said inner integral in a second area of said second boundary element ($S_j$), said second area being determined by a cut-off distance ($r_{cut}$) depending on said skin depth.

3. A device for calculating an interaction integral according to claim 2, wherein a radial component of said inner integral is determined through a Double Exponential or DE transform.

4. A device for calculating an interaction integral according to claim 1, said device comprising:

   - means for calculating an outer integral over a first area (ABCD) of said first boundary element ($S_i$), said first area (ABCD) being determined by the intersection of said first boundary element ($S_i$) with a volume obtained by projecting said second boundary element ($S_j$) over a predefined cut-off distance ($r_{cut}$) depending on said skin depth.

5. A device for calculating an interaction integral according to claim 2 or 4, wherein said cut-off distance ($r_{cut}$) is directly proportional to said skin depth.

6. A device for calculating an interaction integral according to claim 2 or 4, wherein said cut-off distance ($r_{cut}$) is determined through said target tolerance.

7. A device for calculating an interaction integral according to any one of claims 1 to 6, wherein said skin depth is smaller than the typical mesh size $d_m$ for said first boundary element ($S_i$) and said second boundary element ($S_j$).

8. A method for calculating an interaction integral representing interaction between a first boundary element ($S_i$) and a second boundary element ($S_j$) of an electrically conductive medium with known conductivity, **CHARACTERIZED IN THAT** said method concentrates processing power of a processing device in an area dependent on skin depth of said medium and a target tolerance.

9. A software program containing instructions to perform the method of claim 8.

Fig. 2

Fig. 1

Fig. 4

Fig. 3

Fig. 5

Fig. 6

EP 2 393 025 A1

Fig. 8

Fig. 7

Fig. 9

Fig. 10A

Fig. 10B

Fig. 10C

**EP 2 393 025 A1**

Europäisches
Patentamt

European
Patent Office

Office européen
des brevets

# EUROPEAN SEARCH REPORT

**Application Number**

EP 10 16 5089

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | COOLS K ET AL: "Design of accurate and efficient boundary-integral-based solvers for the study of electromagnetic scattering", COMPUTATIONAL ELECTROMAGNETICS INTERNATIONAL WORKSHOP, 2009. CEM 2009, IEEE, PISCATAWAY, NJ, USA, 20 July 2009 (2009-07-20), pages 24-29, XP031523370, ISBN: 978-1-4244-4248-5 * the whole document * | 1-9 | INV. G06F17/50 |
| A | YLA-OIJALA ET AL: "Analysis of surface integral equations in electromagnetic scattering and radiation problems", ENGINEERING ANALYSIS WITH BOUNDARY ELEMENTS, ELSEVIER, vol. 32, no. 3, 29 January 2008 (2008-01-29), pages 196-209, XP022437173, ISSN: 0955-7997, DOI: DOI:10.1016/J.ENGANABOUND.2007.08.004 * the whole document * | 1-9 | |
| A,D | CHAKRABORTY S ET AL: "Evaluation of Green's Function Integrals in Conducting Media", IEEE TRANSACTIONS ON ANTENNAS AND PROPAGATION, IEEE SERVICE CENTER, PISCATAWAY, NJ, US, vol. 52, no. 12, 1 December 2004 (2004-12-01), pages 3357-3363, XP011123004, ISSN: 0018-926X, DOI: DOI:10.1109/TAP.2004.836430 * the whole document * | 1-4 | TECHNICAL FIELDS SEARCHED (IPC)<br><br>G06F |

-/--

The present search report has been drawn up for all claims

| Place of search | Date of completion of the search | Examiner |
|---|---|---|
| Munich | 7 December 2010 | Lerbinger, Klaus |

EPO FORM 1503 03.82 (P04C01)

Europäisches
Patentamt
European
Patent Office
Office européen
des brevets

## EUROPEAN SEARCH REPORT

Application Number

EP 10 16 5089

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2009/121167 A1 (UNIV MANITOBA [CA]; OKHMATOVSKI VLADIMIR [CA]; AL-QEDRA MOHAMMED A I [])<br>8 October 2009 (2009-10-08)<br>* the whole document *<br>----- | 1-9 | |
| | | | **TECHNICAL FIELDS SEARCHED (IPC)** |

The present search report has been drawn up for all claims

| Place of search | Date of completion of the search | Examiner |
|---|---|---|
| Munich | 7 December 2010 | Lerbinger, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................................
& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 10 16 5089

This annex lists the patent family members relating to the patent documents cited in  the above-mentioned European search report.
The members are as contained in the European Patent Office EDP file on
The European Patent Office is in no way liable for these particulars which are merely given for the purpose of information.

07-12-2010

| Patent document cited in search report | Publication date | Patent family member(s) | Publication date |
|---|---|---|---|
| WO 2009121167 A1 | 08-10-2009 | NONE | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6051027 A
- US 20090228847 A
- US 6353801 B

**Non-patent literature cited in the description**

- Evaluation of Green's Function Integrals in Conducting Media. *IEEE Transactions on Antennas and Propagation,* December 2004, vol. 52 (12